# EUROPEAN PATENT APPLICATION

(11) **EP 3 214 910 A1**
(43) Date of publication of application: **06.09.2017**
(21) Application number: 17158389.1
(22) Date of filing: 28.02.2017
(51) Int. Cl.: H05K 7/14, H04Q 1/00, H05K 7/18

(54) **RACK UNIT WITH PIVOTABLE REAR DESIGNATION PLATE**

(30) Priority: 29.02.2016 US 201662301090 P
(71) Applicant: AVP Mfg & Supply Inc., Cambridge, Onatio N1R 5S3 (CA)
(72) Inventor: BAKER, Daniel Laverne, Orillia, Ontario L3V 3M9 (CA); BRAZEAU, David Raymond, Kitchener, Ontario N2B 3G5 (CA); PYLYPIW, David Julius, Cambridge, Ontario N3H 3R6 (CA)
(74) Representative: Mannion, Daniel James

(57) **Abstract**

The disclosure is directed at a rack unit that provides an improved system and method for users to identify the ports within the rack unit. The rack unit includes a designation plate pivots between a lowered position where the user can identify the ports within the rack unit and a raised position where the user has more space to insert a cable into an identified port.

## Description

### Cross-reference to other Applications

This application claims the benefit of United States Patent Application No. 62/301,090, filed February 29, 2016, which is incorporated herein by reference.

### Field of the Disclosure

The disclosure is directed at a rack unit for use with electronic equipment and more specifically at a rack unit having a pivotable rear designation plate.

### Background of the Disclosure

The use of racks, or rack enclosures, in the electronics industry to house electronic equipment is well known. These racks allow multiple types and pieces of electronic equipment (which may also be seen as rack units) to be housed in close proximity with each other, preferably in a stackable format. In many known racks, the rack units are typically stacked quite close together allowing for limited space to access the rear of the rack units.

In some cases, such as within the commercial broadcast, telecom, or satellite industries, the rack units include a set of ports at the rear of the rack unit. The ports typically receive cables (which are connected to other devices) to receive data or signals from these other devices. However, with the limited space available when the rack units are placed within racks and with the numerous amount of ports in a rack unit, it is typically difficult to identify the correct port into which a cable should be inserted. It is also difficult for users to insert a cable after the rack unit has been placed in the rack.

Therefore, there is provided a rack unit having a pivotable rear designation plate.

### Summary of the Disclosure

The disclosure is directed at a rack unit having a pivotable rear designation plate. The pivotable rear designation plate, which may be a single piece or may be an integrated assembly, provides an improved method and system for identifying the ports within the rack unit so that a user is able to more clearly determine which port to insert one or more cables. By being pivotable, the rear designation plate may be moved out of the way when the cable is being inserted into the port in order to provide more space for a user to work.

In one aspect of the disclosure, there is provided a rack unit including a mounting plate for mounting the rack unit to a rack unit enclosure; a set of ports integrated with the mounting plate for receiving cables; and a designation plate assembly pivotably connected to the mounting plate.

In another aspect, the designation plate assembly is pivotably mounted to a top edge of the mounting plate. In yet another aspect, the designation plate assembly includes a numbered section. In a further aspect, the designation plate assembly includes a label section.

In an aspect, the rack unit further includes a pair of side plates, the side plates mounted to opposite ends of the rear plate. In another aspect, the rack unit also includes a cable support bar, the cable support bar connected at each end to one of the pair of side plates.

In one other aspect, the designation plate assembly pivots between a lowered position, a raised position and a halfway position.

In a second aspect of the disclosure, there is provide apparatus for receiving cables from electronic equipment including at least one rack unit, the at least one rack unit including a mounting plate for mounting the rack unit to a rack enclosure; a set of ports integrated with the mounting plate; and a designation plate pivotably connected to the mounting plate.

In another aspect, the rack unit further includes a rack enclosure for receiving the at least one rack unit. In a further aspect, the at least one rack unit is stacked with respect to other rack units within the rack enclosure. In yet a further aspect, each of the at least one rack unit includes holes within the mounting plate for mounting of the at least one rack unit to the rack enclosure.

In yet another aspect, the designation plate includes a numbered section; and a label section. In another aspect, designation plate assembly includes a rear plate; and a designation plate. In yet a further aspect, the rear plate is pivotably connected to the mounting plate. In yet another aspect, the designation plate includes a magnet for attaching the designation plate to the rear plate.

### Brief Description of the Drawings

Embodiments of the present disclosure will now be described, by way of example only, with reference to the attached Figures.
Figure 1 a is a perspective view of a rack unit with a pivotable rear designation plate in a lowered position;
Figure 1b is a perspective view of the rack unit of Figure 1 a with the pivotable rear designation plate in a raised position;
Figure 1c is a perspective view of the rack unit of Figure 1 a with a pivotable rear designation plate in a halfway position;
Figure 1d is an exploded view of a portion of the rack unit of Figure 1 a;
Figure 1e is an exploded view of a portion of the rack unit of Figure 1 b;
Figure 2a is a front view of another embodiment of a rack unit with a pivotable rear designation plate in a lowered position;
Figure 2b is a perspective view of the rack unit of Figure 2a;
Figure 3a is a front view of the rack unit of Figure 2a with a pivotable rear designation plate in a raised position;
Figure 3b is a perspective view of the rack unit of Figure 3a;
Figure 4a is a front view of the rack unit of Figure 2a with a pivotable rear designation plate in a halfway position;
Figure 4b is a perspective view of the rack unit of Figure 4a;
Figure 5a is a perspective view of another embodiment of a rack unit with a pivotable rear designation plate in a lowered position;
Figure 5b is a perspective view of the rack unit of Figure 5a with the pivotable rear designation plate in a raised position;
Figure 5c is a perspective view of the rack unit of Figure 5a with a pivotable rear designation plate in a halfway position;
Figure 6a is a side view of a set of stacked rack units;
Figures 6b to 6d are side views of a rack unit with a pivotable rear designation plate in lowered, raised and halfway positions, respectively;
Figure 7a is a side view of another embodiment of a set of stacked rack units;
Figures 7b to 7d are side views of a rack unit with a pivotable rear designation plate in lowered, raised and halfway positions, respectively;
Figure 8a is a side view of yet another embodiment of a set of stacked rack units;
Figures 8b to 8d are side views of a rack unit with a pivotable rear designation plate in lowered, raised and halfway positions, respectively;
Figure 9a is a perspective view of another embodiment of a rack unit with a pivotable rear designation plate in a lowered position;
Figure 9b is an exploded view of a portion of the rack unit of Figure 9a;
Figure 9c is a partial side view of the rack unit of Figure 9a;
Figure 10a is a perspective view of the rack unit of Figure 9a with a pivotable rear designation plate in a halfway position;
Figure 10b is an exploded view of a portion of the rack unit of Figure 10a;
Figure 10c is a partial side view of the rack unit of Figure 10a;
Figure 11a is a perspective view of the rack unit of Figure 9a with a pivotable rear designation plate in a raised position;
Figure 11b is an exploded view of a portion of the rack unit of Figure 11 a;
Figure 11c is a partial side view of the rack unit of Figure 11 a;
Figure 12a is a side view of yet another embodiment of a set of stacked rack units;
Figures 12b to 12d are side views of a rack unit with a pivotable rear designation plate in lowered, raised and halfway positions, respectively;
Figure 13a is a perspective view of another embodiment of a rack unit with a pivotable rear designation plate; and
Figure 13b is an exploded rear view of a designation assembly.

### Detailed Description of the Preferred Embodiment

The disclosure is directed at a method and system for identifying ports in a rack unit. In one embodiment, the disclosure is directed at a rack unit including a pivotable rear designation plate.

The disclosure provides a method and apparatus for facilitating the identification of ports within the rack and for also facilitating the insertion of a cable into an identified port. By providing a pivotable rear designation plate, after a user identifies the port into which a cable is to be inserted, the designation plate may be pivoted so that there is more space provided to the user to insert the cable. This is an advantage especially when multiple racks have been mounted to a rack enclosure.

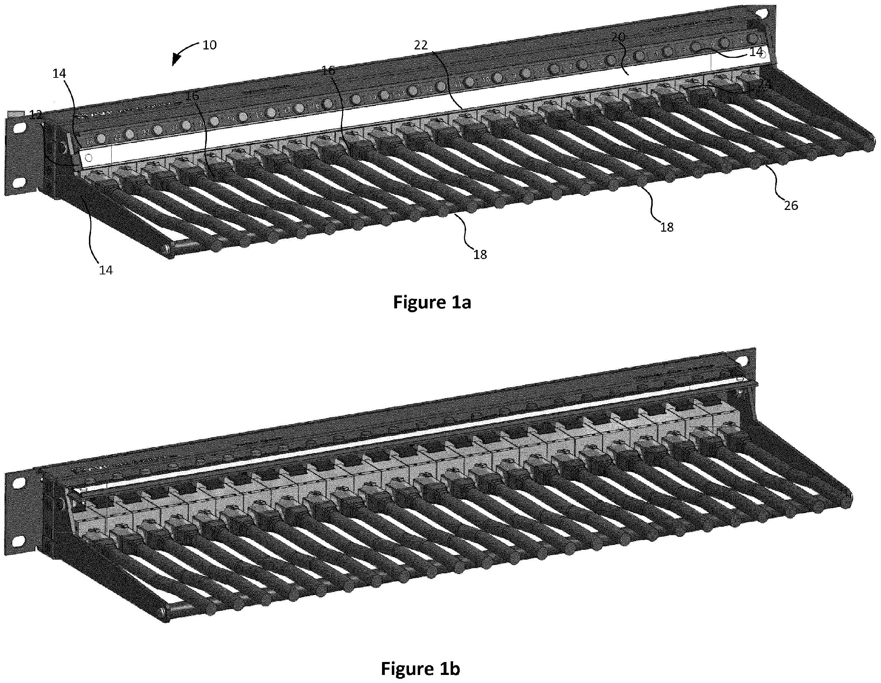

Turning to Figures 1a to 1c, perspective views of a rack unit having a pivotable rear designation plate in a lowered, a raised and a halfway position, respectively, are provided. The rack unit 10 includes a back or mounting plate 12 which include holes 14 that allow the rack unit 10 to be mounted to a rack enclosure (not shown). The rack unit 10 further includes a set of ports 16 for receiving cables 18, which are, in turn, connected to various other equipment, such as, but not limited to, apparatus for the transmission of signals for telecommunications, broadcasts, satellite transmissions and/or Internet Protocol (IP) broadcast/streaming. More specifically, the cables may be connected to, but not limited to, switches, distribution amplifiers, microphones, cameras, production consoles, computers, intercom, transmission equipment, lighting, fiber networks, amplifiers, monitors, projectors, and electronic or electric instruments. This type of equipment may be found in stadiums, theatres, boardrooms or production rooms and the like. In a preferred embodiment, the rack unit is used for an Ethernet connector panel.

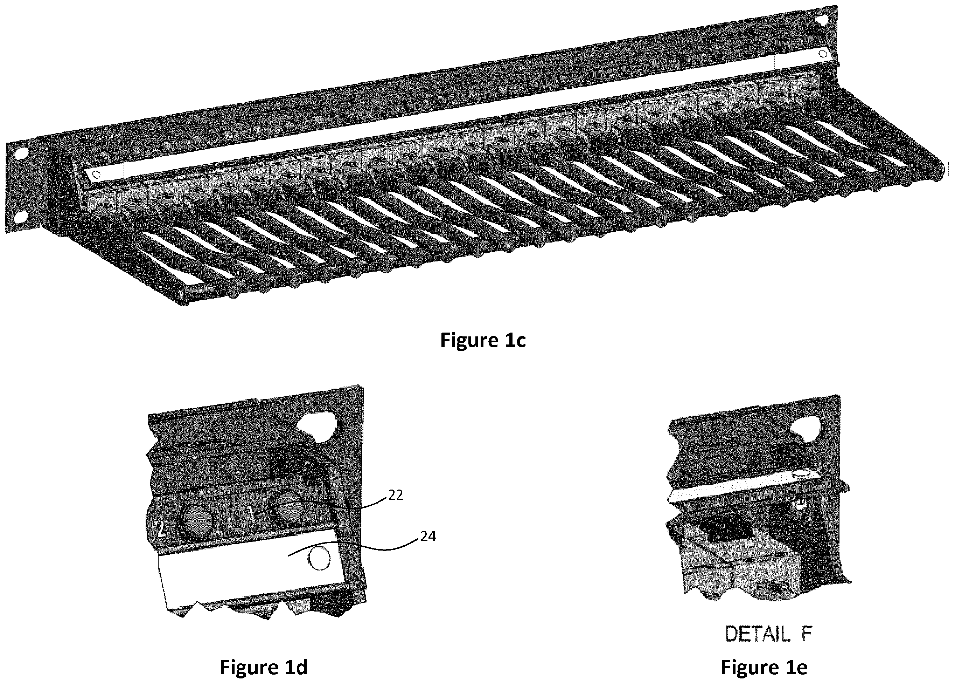

The rack unit 10 further includes a rear designation plate 20, which in Figure 1a is shown in the lowered position. In one embodiment, the rear designation plate 20 is pivotably mounted to the back plate 12 of the rack unit 10. The pivot is preferably located along a top edge of the rear designation plate 20. In the current description, the term "rear" is being used to reflect the direction that the designation plate 20 is facing with respect to the rack unit 10. The designation plate 20 further includes a numbered section 22 and a label section 24. The numbered section 22 (shown in a partial exploded view of Figure 1d) may provide a user with one level of understanding as to which port 16 a cable 18 is to be attached or connected to or to provide identification for each of the ports. The label section 24 provides a further identification to the user. This further identification may include, but is not limited to, the equipment for which the port is expecting to be connected to or may provide further information associated with each of the ports to assist the user in recognizing the port to which a cable should be connected. In some current rack units, identification of the ports is difficult as space is typically limited both on the rack unit and, even more so, when multiple rack units are mounted to a rack enclosure. Other methods of identification are contemplated, such as, but not limited to, colour coding. In some cases, the designation plate may only include a label section such as for panels where either there is no room for a numbered section, or in markets where products with fewer features are required due to budget realities in those markets. As will be understood, any number of identification methods may be integrated within the pivotable rear designation plate 20. Figure 1d provides an exploded view of Figure 1 a.

In the current embodiment, the rack unit 10 further includes a pair of side plates 25 located at each end of the rack unit 10 which are integrated with a cable bar 26 that provides support to the cables 18 once they are connected to the rack unit 10. In the current embodiment, the side plates 25 are designed such that the cable bar 26 is located about six inches from the ports 16 although other distances are contemplated.

Turning to Figure 1b, a perspective view of the rack unit of Figure 1 a with the rear designation plate in a raised position is shown. As discussed above, there is typically limited space at a rear of the rack unit (especially when they are mounted together in a rack enclosure) and therefore, by having the designation plate 20 pivotable with respect to the back plate 12, a user may be able to more easily identify the ports prior to insertion of the cable or cables and then raise or pivot the rear designation plate away from the ports (from the lowered position to the raised position) to give themselves more room to insert the cable or cables into the correct or identified port or ports. Further details may be seen in Figure 1 e which is an exploded view of a portion of Figure 1 b. Figure 1c provides a perspective view of the rear designation plate 20 pivoted to an intermediate or halfway position which is between the raised and lowered positions.

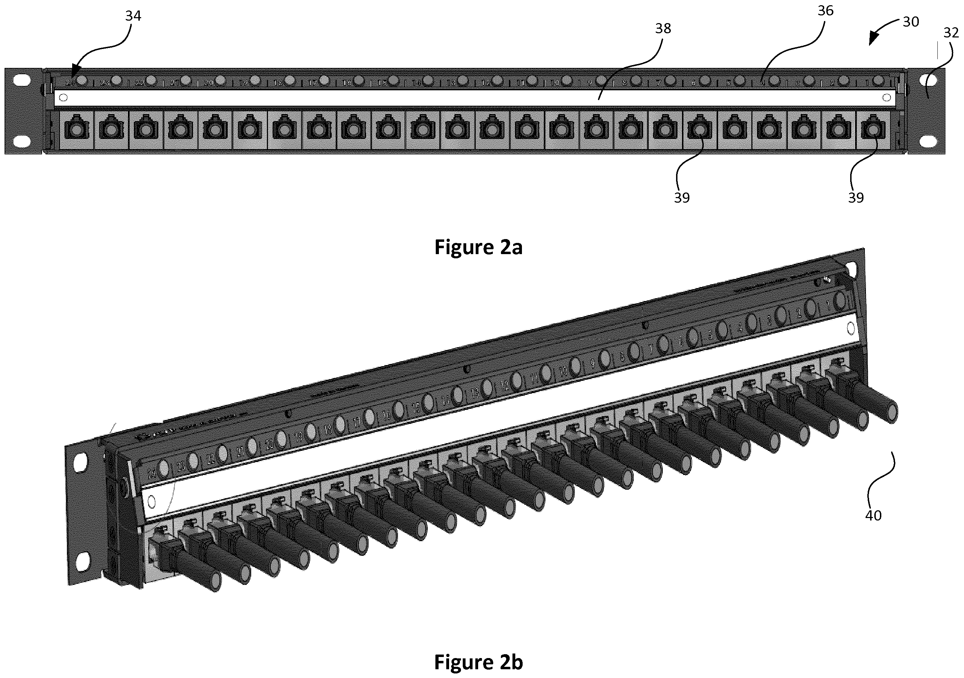

Turning to Figures 2a and 2b, a front view and a perspective view are shown of another embodiment of a rack unit with a pivotable rear designation plate in a lowered position. As shown, the rack unit 30 includes a back plate 32 for mounting the rack unit to a rack unit enclosure. The pivotable rear designation plate 34 includes a numbered section 36 and a description or label section 38 such that the ports 39 of the rack unit 30 can be identified. In Figure 2b, cables 40 are shown inserted into each of the ports 39 in order to connect external equipment to the rack unit 30.

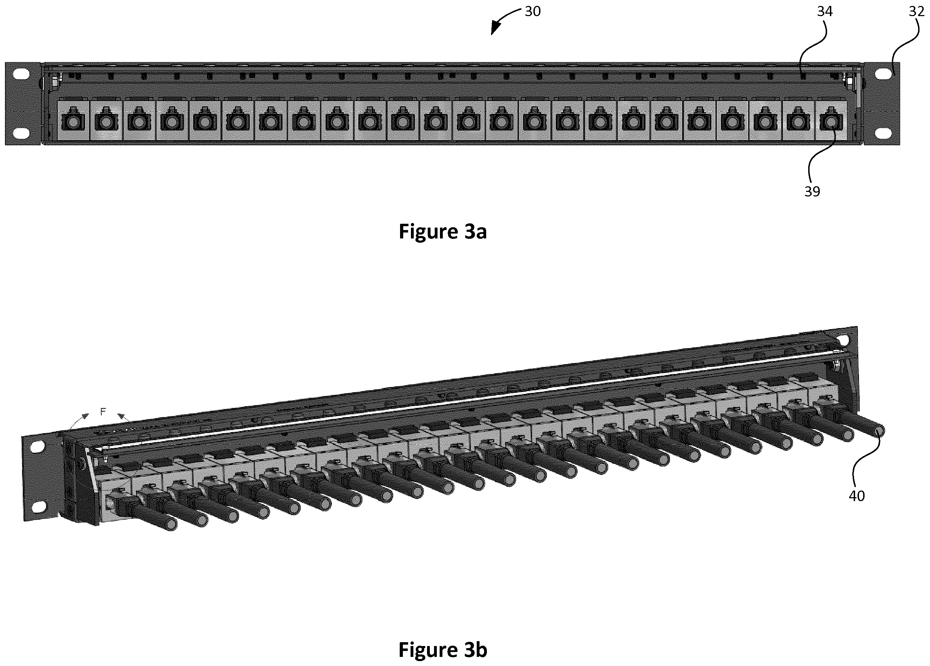

Turning to Figures 3a and 3b, front and perspective views of the rack unit of Figure 2a with the pivotable rear designation plate in a raised position are provided. When the pivotable rear designation plate 34 is placed in the raised position, it can be seen that access to the ports is improved. In other words, there is more space for a user to plug a cable into the ports after looking at the numbered section 36 and/or the label section 38 to identify the port 39 which the user wishes to plug the cable 40 into.

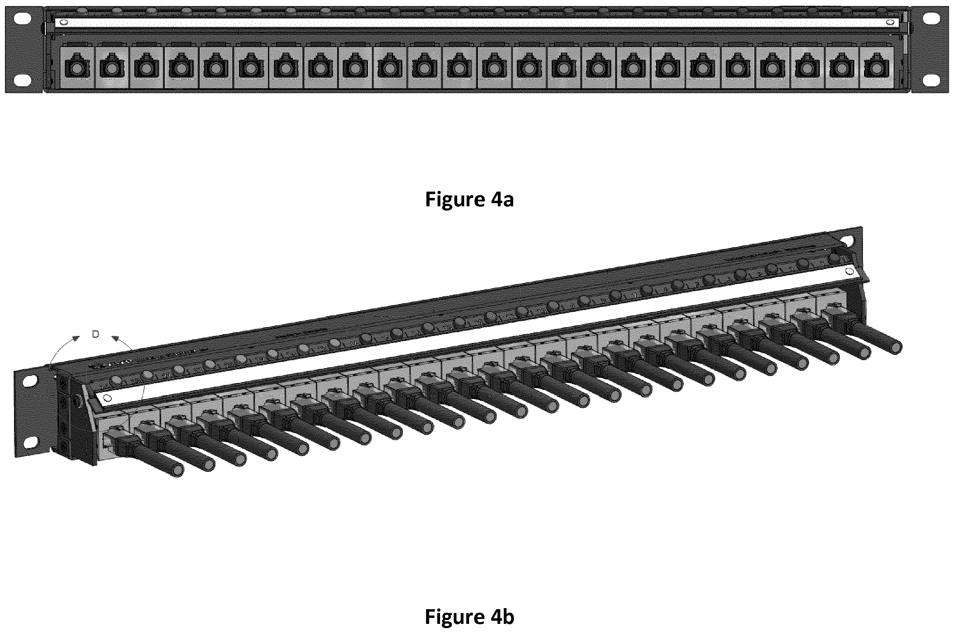

Turning to Figures 4a and 4b, front and perspective views of the rack unit of Figure 2a with a pivotable rear designation plate in a halfway position are shown. In the halfway position, the space available for the user to insert a cable is increased over the amount of space when the designation plate is in the lowered position. However, with the designation plate 34 in the halfway position, the user may be able to confirm or determine the port 39 to which they are connecting the cable 40 while they are inserting the cable.

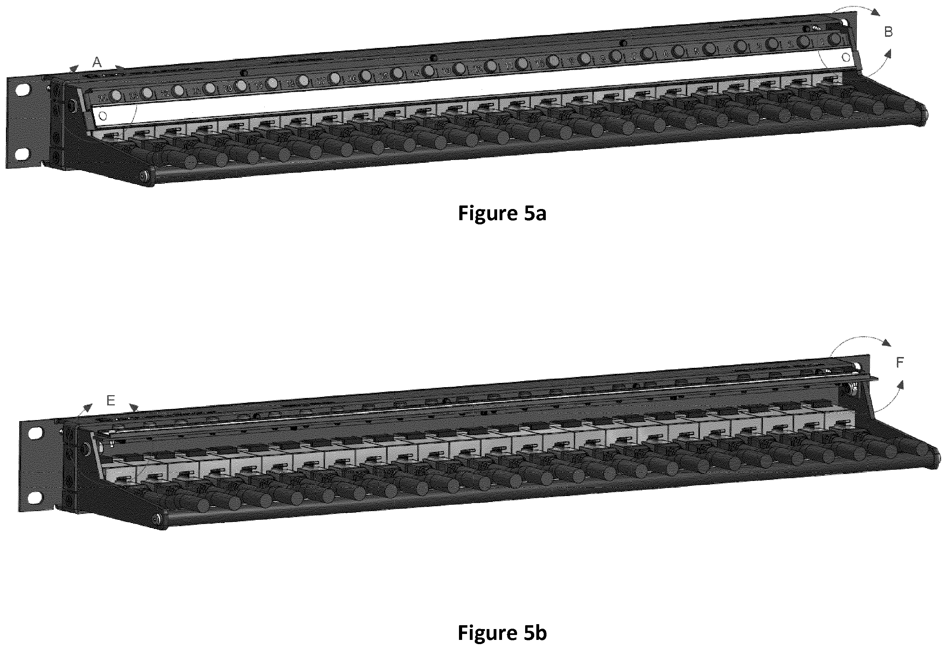

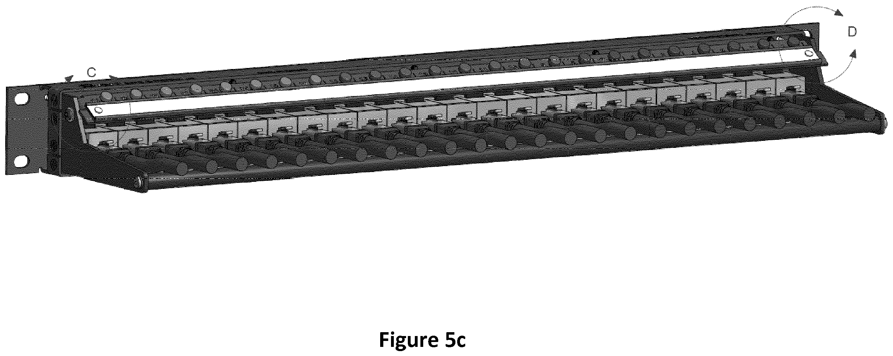

Turning to Figures 5a to 5c, perspective views of another embodiment of a rack unit having a rear designation plate in a lowered, raised and halfway position, respectively, are provided. The rack unit 10 of Figures 5a to 5c is similar to the rack unit of Figures 1 a to 1 c (using similar numbering) with one difference being the distance between the cable bar 26 and the ports 16. In the current embodiment, the cable bar 26 is four (4) inches away from the ports 16. It will be understood that the distance between the cable bar 26 and the ports 16 provides a different embodiment of the disclosure. An advantage of the disclosure is that the pivotable rear designation plate allows users to more easily recognize and identify ports when the rear designation plate is in a lowered position and is out of the way and not affecting a user's ability to plug cables into the ports of the rack unit when in a raised position.

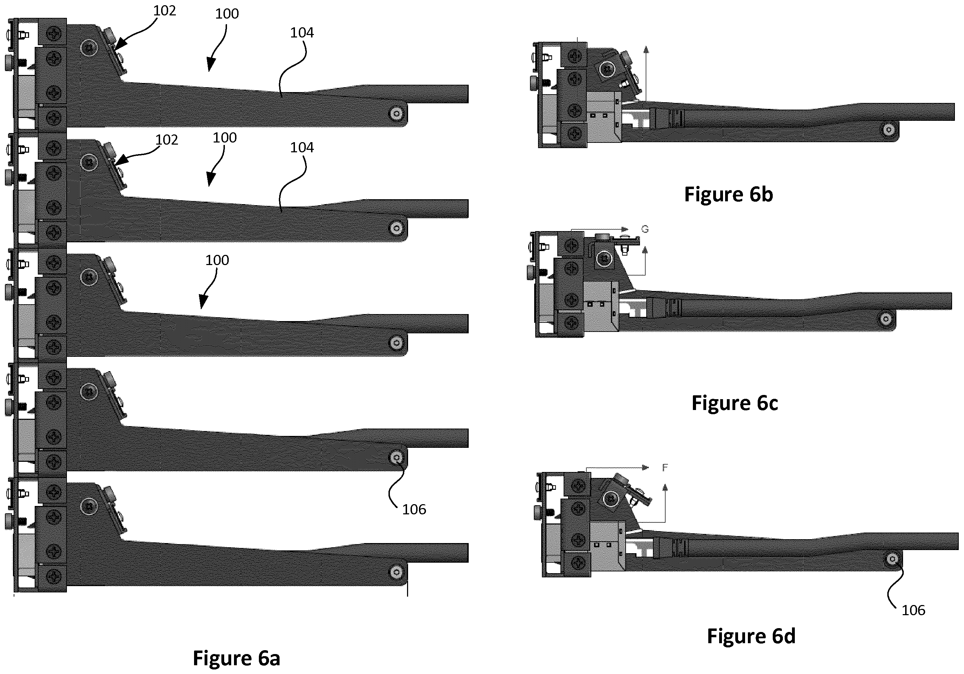

Turning to Figure 6a, a side view of a plurality of rack units mounted in a stack formation is provided. In Figure 6a, each of the rack units 100 include a rear designation plate 102 which is in the lowered position. The rack units further include a side plate 104 which supports a cable bar 106 that is located approximately six inches from the ports. The side view of Figures 6b to 6d provide further understanding of the design of the current embodiment and also reflects the increased space provided to the user to insert or remove cables when the rear designation plate is in the raised (Figure 6c) or halfway (Figure 6d) positions with respect to when the rear designation plate is in the lowered (Figure 6b) position especially when a set of racks are in a stacked formation.

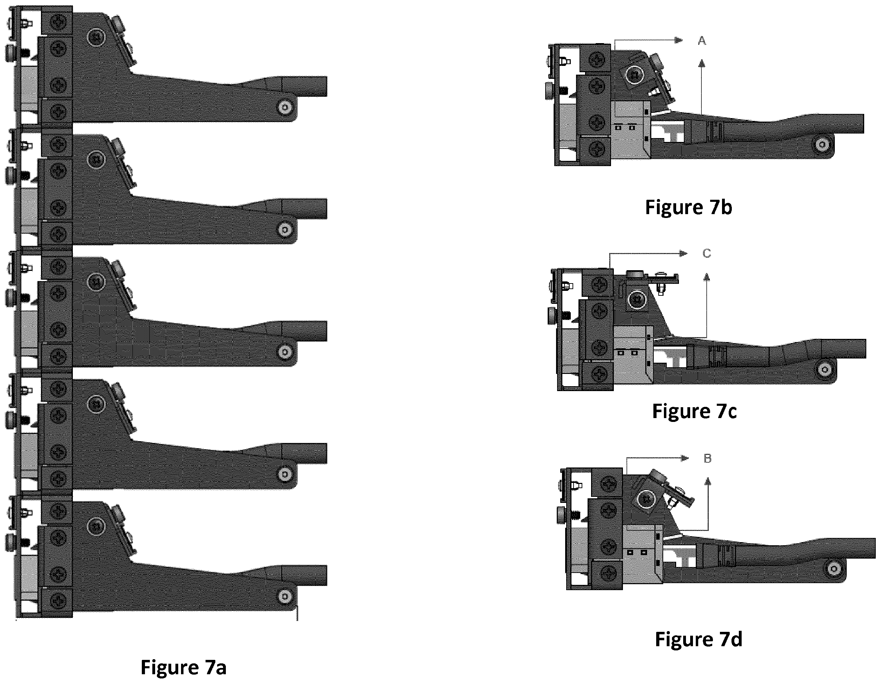

Turning to Figures 7a to 7d, another embodiment of a set of rack units mounted in a stacked formation (Figure 7a) and side views (Figure 7b to Figure 7d) of a single rack unit are shown. Figures 7a to 7d are identical with Figures 6a to 6d with the exception that the side plates of the embodiment are designed such that the cable bar is supporting the cables at a distance of approximately four inches from the ports.

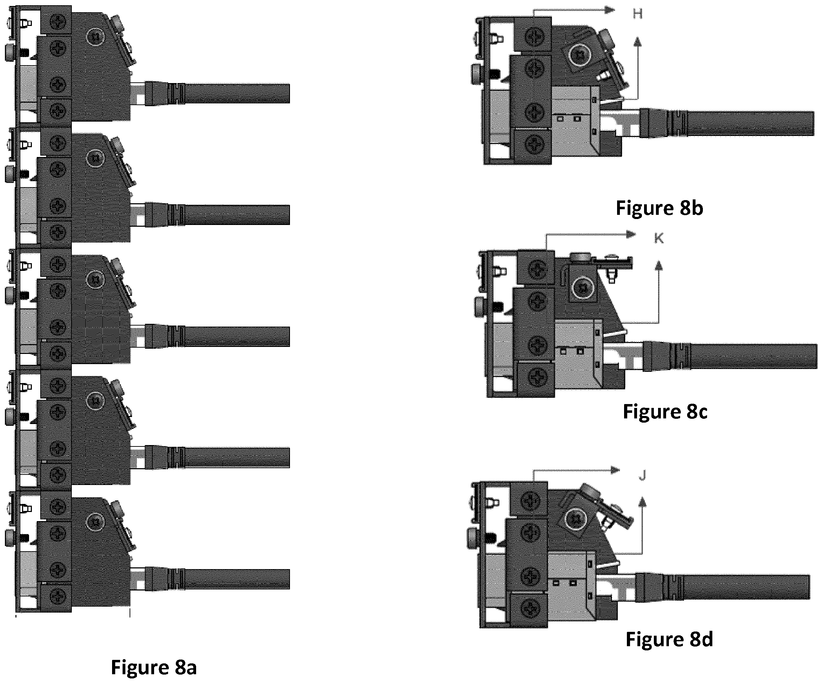

Turning to Figure 8a to 8d, yet a further embodiment of a set of mounted rack units (Figure 8a) and side views (Figures 8b to 8d) of one of the rack units are shown. Figures 8a to 8d are identical with Figures 6a to 6d with the exception that the current embodiment does not include side plates or a cable bar.

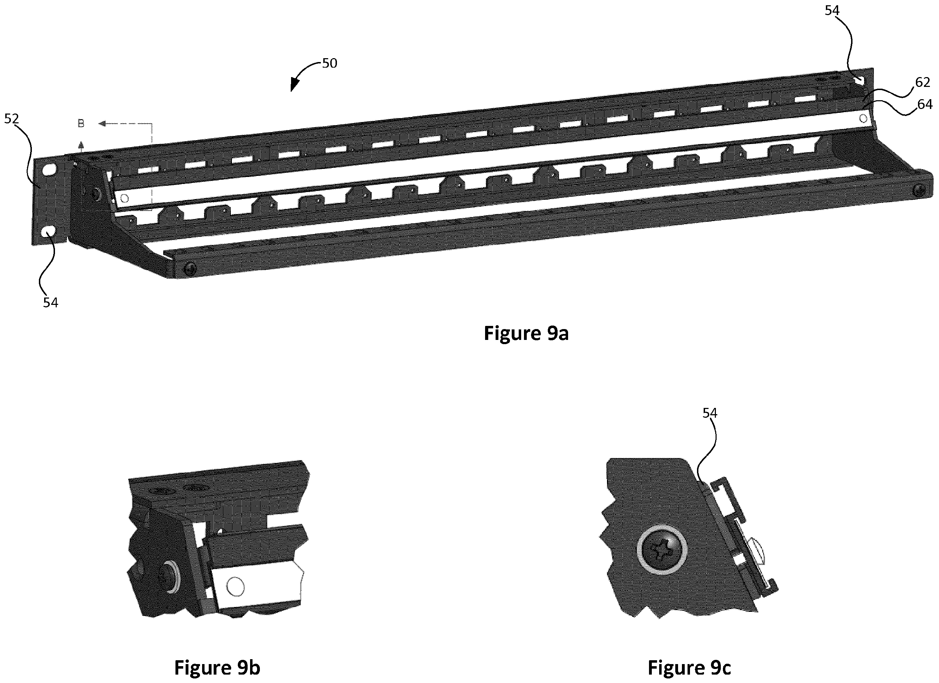

Turning to Figure 9a, a perspective view of another embodiment of a rack unit in accordance with the disclosure is shown. Figure 9b is an exploded view of a portion of the embodiment of Figure 9a and Figure 9c is a partial side view of the embodiment of Figure 9a. The rack unit 50 includes a back plate 52 which include holes 54 that allow the rack unit 50 to be mounted to a rack enclosure, preferably to a back of the rack enclosure. The rack unit 50 includes a set of ports for receiving cables such as disclosed above with respect to the other embodiments.

The rack unit 50 further includes a pivotable rear support plate 56 in a lowered position. Figure 9b provides an enlarged view of the rear plate 56. The rear support plate 56 is pivotably mounted to the back or mounting plate 52 of the rack unit 50. The pivot point of the rear support plate is preferably located along a top edge of the rear plate 56. Attached to the rear plate 56 is a designation plate 58 wherein the combination of the rear plate 56 and the designation plate 58 can be seen as a rear designation assembly or pivotable rear designation plate 60. The designation plate 58 further includes a numbered section 62 and a label section 64. Similar to the previously disclosed embodiments, the numbered section 62 provides a user with one level of understanding as to which port a cable is attached while the label section 64 provides further identification of the equipment to which the cable is attached or further identification of the port. As will be understood, the numbered section and the label section may be used to convey any type of information relating to the rack to a user. In one embodiment, the designation plate 58 includes a magnet for mounting of the designation plate 58 onto the rear plate 56, which is preferably fabricated out of metal.

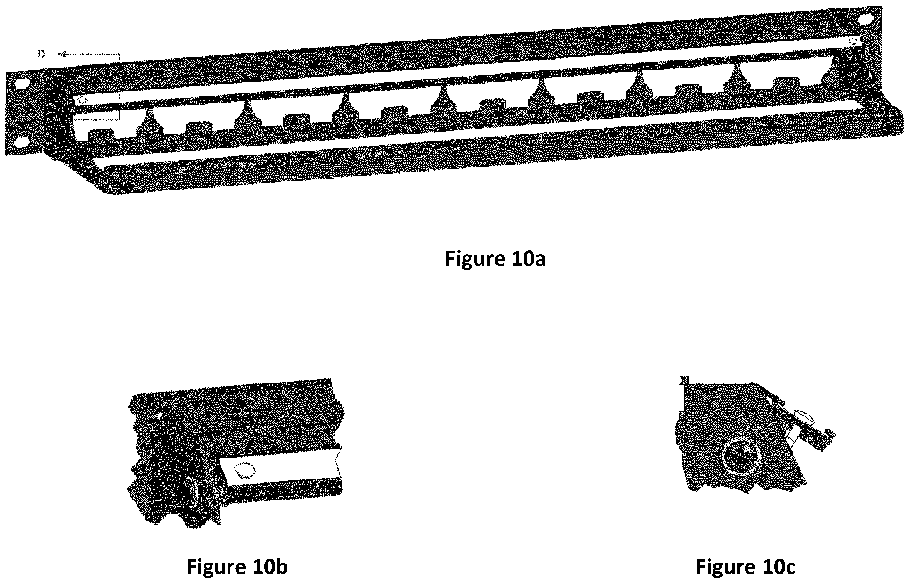

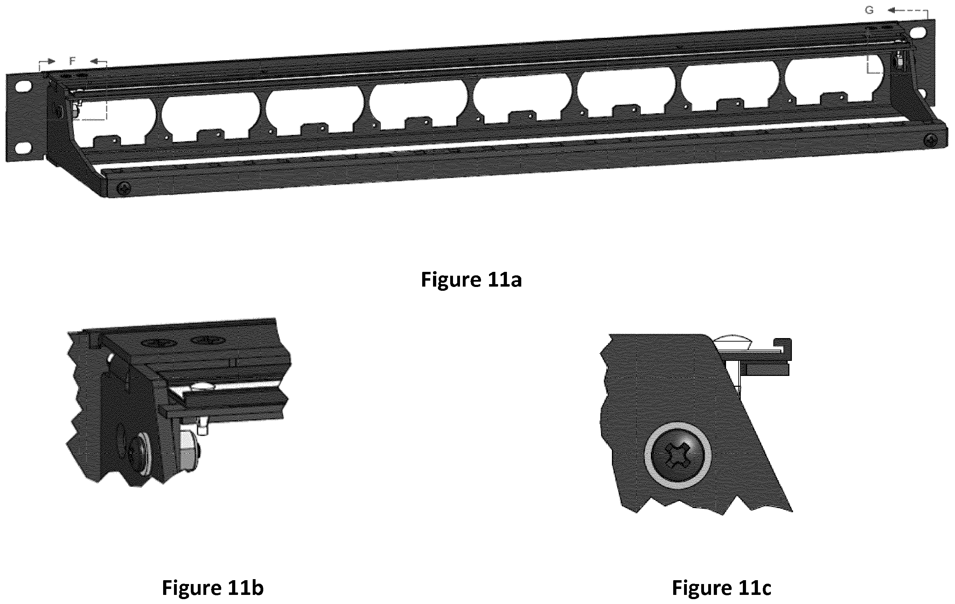

Figure 10a is a perspective view of the rack unit of Figure 9a with the rear plate in a halfway position while Figures 10b and 10c are similar views to Figures 9b and 9c with the rear plate in a halfway position. Figures 11 a to 11c show the rack unit with the rear plate in a raised position. In the embodiment of Figures 9 to 11, information that is listed on the numbered section and/or the label section of the designation plate may be more easily updated by removing the designation plate from contact with the rear plate and then making the necessary changes to the numbered or label section, or both, and then re-attaching or reconnecting, the designation plate to the rear plate.

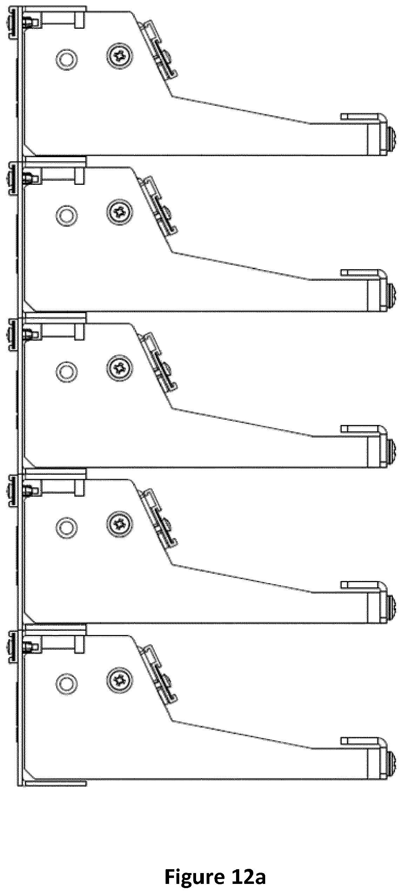

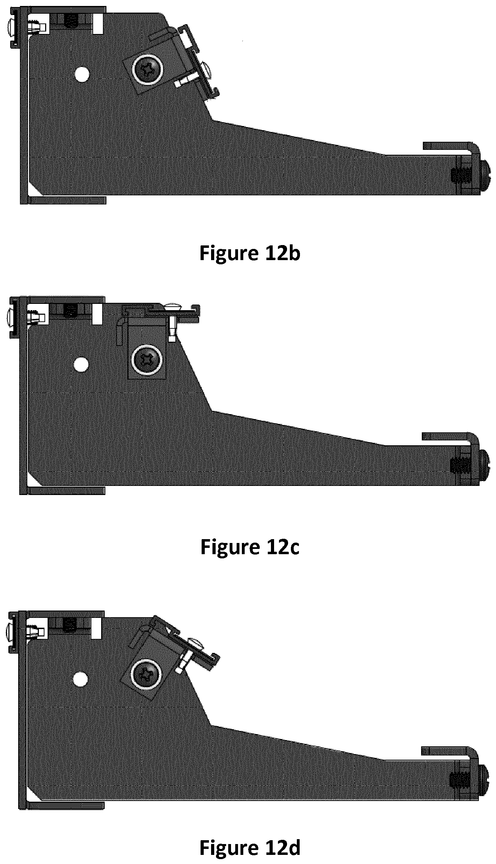

Turning to Figure 12a, a side view of a set of rack units (in accordance with the embodiment of Figure 9a) is shown. In Figure 12a, the rear designation assembly is shown in the lowered position. If a user wishes to change some of the information that is listed on the designation plate, the user can simply detach it from the rear plate. Figures 12b to 12d are side views of a rack unit (such as the one shown in Figure 9a) with the rear designation plate or assembly in the raised, halfway and lowered positions, respectively.

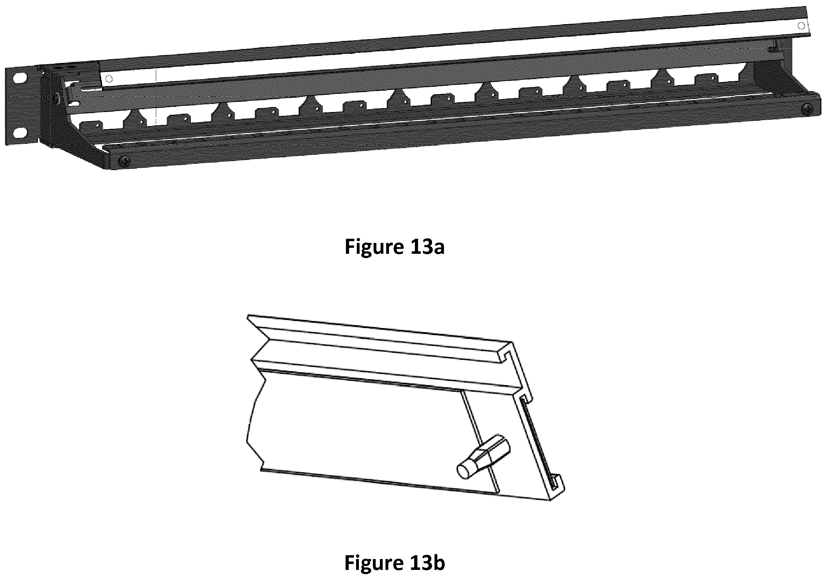

Turning to Figure 13a, a perspective view of a rack unit with the designation plate shifted with respect to the rear plate is shown. As shown in Figure 13b, the designation plate includes a magnetic backing 80 which allows the designation plate to be mounted to the metal rear plate. Alternatively, the designation plate may be fastened to the rear plate via fasteners, such as, but not limited to, screws and the like.

In the preceding description, for purposes of explanation, numerous details are set forth in order to provide a thorough understanding of the embodiments. However, it will be apparent to one skilled in the art that these specific details are not required.

The above-described embodiments are intended to be examples only. Alterations, modifications and variations can be effected to the particular embodiments by those of skill in the art without departing from the scope, which is defined solely by the claims appended hereto.

## Claims

1. A rack unit comprising:
a mounting plate for mounting the rack unit to a rack unit enclosure;
a set of ports integrated with the mounting plate for receiving cables; and
a designation plate assembly pivotably connected to the mounting plate.

2. The rack unit of Claim 1 wherein the designation plate assembly is pivotably mounted to a top edge of the mounting plate.

3. The rack unit of Claim 1 wherein the designation plate assembly comprises a numbered section.

4. The rack unit of Claim 1 wherein the designation plate assembly comprises a label section.

5. The rack unit of Claim 1 further comprising:
a pair of side plates, the side plates mounted to opposite ends of the mounting plate; and
a cable support bar, the cable support bar connected at each end to one of the pair of side plates.

6. The rack unit of Claim 1 wherein the designation plate assembly pivots between a lowered position, a raised position and a halfway position.

7. Apparatus for receiving cables from electronic equipment comprising:
at least one rack unit, the at least one rack unit including:
a mounting plate for mounting the rack unit to a rack enclosure;
a set of ports integrated with the mounting plate; and
a designation plate assembly pivotably connected to the mounting plate.

8. The apparatus of Claim 7 further comprising:
a rack enclosure for receiving the at least one rack unit.

9. The apparatus of Claim 8 wherein the at least one rack unit is stacked with respect to other rack units within the rack enclosure.

10. The apparatus of Claim 8 wherein each of the at least one rack unit comprises holes within the mounting plate for mounting of the rack unit to the rack enclosure.

11. The apparatus of Claim 7 wherein the designation plate assembly comprises:
a numbered section; and
a label section.

12. The rack unit of Claim 1 wherein the designation plate assembly comprises:
a rear plate; and
a designation plate.

13. The rack unit of Claim 12 wherein the rear plate is pivotably connected to the mounting plate.

14. The rack unit of Claim 13 wherein the designation plate assembly comprises a magnet for attaching the designation plate to the rear plate.
